# EUROPÄISCHE PATENTANMELDUNG

(11) **EP 3 521 843 A1**
(43) Veröffentlichungstag der Anmeldung: **07.08.2019**
(21) Anmeldenummer: 19153865.1
(22) Anmeldetag: 28.01.2019
(51) Int. Cl.: G01R 31/02

(54) **SYSTEM ZUR ÜBERWACHUNG VON TRANSFORMATORENSTATIONEN**

(30) Priorität: 02.02.2018 DE 102018201635
(71) Anmelder: Stadtwerke Karlsruhe GmbH, 76185 Karlsruhe (DE)
(72) Erfinder: Bastian, Uwe, 76532 Baden-Baden (DE); Spatz, Wolfgang, 76185 Karlsruhe (DE)
(74) Vertreter: Grünecker Patent- und Rechtsanwälte PartG mbB

(57) **Zusammenfassung**

Die Erfindung umfasst ein System zur Überwachung einer Transformatorenstation (1), umfassend wenigstens zwei Sensoreinrichtungen (6) zur Erfassung der Stromstärke und/oder Spannung in jeweils einem Leitungsabschnitt einer Transformatorenstation (1), und eine mit den Sensoreinrichtungen (6) verbundene Steuereinrichtung (5), welche ausgebildet ist, Messsignale der Sensoreinrichtungen (6) zu empfangen und in Übertragungssignale zur drahtlosen Übermittlung über ein LoRaWAN Netzwerk zu konvertieren, wobei die Übertragungssignale jeweils einen Stromstärkewert und/oder Spannungswert und eine Identifikation des zugehörigen Leitungsabschnitts umfassen, und wobei die Steuereinrichtung (5) außerdem eine Übertragungseinheit (10) umfasst, die ausgebildet ist, die Übertragungssignale drahtlos über ein LoRaWAN Netzwerk an eine externe Empfangseinheit zu übermitteln.

## Beschreibung

Die Erfindung betrifft ein System und ein Verfahren zur Überwachung einer Transformatorenstation.

Transformatorenstationen werden eingesetzt, um die elektrische Spannung des Mittelspannungsnetzes auf die in den Niederspannungsnetzen verwendete Spannung zu transformieren. Eine Transformatorenstation oder kurz "Trafostation", besteht üblicherweise aus einem Gebäude, wenigstens einem Transformator, einer Mittelspannungsschaltanlage und mindestens einer Niederspannungsverteilung. Inzwischen sind auch kompakte Transformatorenstationen bekannt, welche kein begehbares Gebäude mehr umfassen.

Es ist bekannt, zur Überwachung solcher Transformatorenstationen Schleppzeigersensoren zu verwenden, mit denen beispielsweise der maximale Stromfluss in gewissen Leitungsabschnitten der Transformatorenstationen überwacht werden kann. Auch Erdschluss- bzw. Kurzschlusssensoren finden Anwendung.

Nachteilig an diesen Lösungen ist, dass zur Überwachung der Transformatorenstationen eine Inaugenscheinnahme der verwendeten Messeinrichtungen erforderlich ist. In großen Ortsnetzen mit einer Vielzahl von Transformatorenstationen führt dies dazu, dass über den laufenden Betrieb der einzelnen Transformatorenstationen dem Netzbetreiber üblicherweise keine Informationen vorliegen und Fehler erst mit großer zeitlicher Verzögerung festgestellt werden können.

Teilweise werden daher mittlerweile Systeme verwendet, welche eine Fernauslesung der Erdschluss- bzw. Kurzschlusssensoren ermöglichen. Dies ermöglicht es zwar, systemkritische Fehler im Betrieb der Transformatorenstationen schneller zu erkennen, über den laufenden Betrieb bzw. mögliche Ursachen der Fehler sind jedoch nach wie vor keine Schlüsse möglich.

Aufgabe der Erfindung ist es daher, ein verbessertes System und ein verbessertes Verfahren zur Überwachung einer Transformatorenstation bereitzustellen. Diese Aufgabe wird durch ein System nach Anspruch 1 und ein Verfahren nach Anspruch 10 gelöst. Vorteilhafte Weiterbildungen der Erfindung sind in den abhängigen Ansprüchen angegeben.

Gemäß der Erfindung ist es also vorgesehen, dass wenigstens zwei Sensoreinrichtungen zur Erfassung der Stromstärke und/oder Spannung in jeweils einem Leitungsabschnitt einer Transformatorenstation bereitgestellt werden. Messsignale dieser Sensoreinrichtungen werden dann durch eine mit diesen Sensoreinrichtungen verbundene Steuereinrichtung in Übertragungssignale oder Sendesignale zur drahtlosen Übermittlung über ein Long Range Wide Area Network, LoRaWAN-Netzwerk, konvertiert, wobei die Übertragungssignale oder Sendesignale jeweils einen Stromstärkewert und/oder Spannungswert und eine Identifikation des zugehörigen Leitungsabschnitts umfassen. Die Übertragungssignale können dann mittels der Übertragungseinheit der Steuereinrichtung über das LoRaWAN-Netzwerk an eine externe Empfangseinheit, beispielsweise eine Leitstelle des Energieversorgers, übermittelt werden. Das System ermöglicht es also, gewissermaßen ortsaufgelöst, also für unterschiedliche Leitungsabschnitte einer Transformatorenstation, Stromstärkewerte und/oder Spannungswerte zu bestimmen, ohne vor Ort in der Transformatorenstation anwesend sein zu müssen. Durch die Verwendung eines LoRaWAN-Netzwerkes ist eine zuverlässige Übertragung möglich, obwohl die Gebäude bzw. Einhausungen von Transformatorenstationen drahtlose Kommunikation üblicherweise nicht ermöglichen, da die entsprechenden Frequenzen die Gebäude/Gehäuse nicht oder nicht ausreichend durchdringen.

Die übermittelten Stromstärkewerte und/oder Spannungswerte erlauben Rückschlüsse über den Betrieb der Transformatorenstationen auch abseits von dem Auftreten systemkritischer Fehler. Dadurch, dass Informationen für mehrere Leitungsabschnitte vorliegen, können auftretende Fehler auch besser analysiert oder gegebenenfalls sogar vermieden werden.

Als "LoRaWAN" wird ein Netzwerkprotokoll für Funkübertragungen bezeichnet. Genutzt werden unterschiedliche Frequenzbereiche der ISM("Industrial, Scientific and Medical")-Bänder. Beispielsweise sind Frequenzen von 433 MHz, 868 MHz und 915 MHz in Verwendung. In der Bundesrepublik Deutschland wird eine Frequenz von 868 MHz verwendet. Die erfindungsgemäß genutzte Frequenz kann also insbesondere bei 433 MHz, 868 MHz und/oder 915 MHz liegen. Ein LoRaWAN-Netzwerk ist üblicherweise sternförmig aufgebaut. Endgeräte kommunizieren mit Gateways, welche die Daten an einen Netzwerk-Server übermitteln. Das LoRaWAN-Netzwerk, kann also wenigstens ein Gateway und wenigstens einen Netzwerkserver umfassen. Der Netzwerkserver kann über eine Schnittstelle verfügen, über die die übermittelten Übertragungssignale an die externe Empfangseinheit übergeben werden.

Der Stromstärkewert und/oder Spannungswert der Übertragungssignale kann ein Mittelwert über einen vorgegebenen Zeitraum sein. Der vorgegebene Zeitraum kann frei konfigurierbar sein. Beispielsweise kann der vorgegebene Zeitraum im Bereich von einer Minute bis zu einer Stunde liegen, beispielsweise bei 15 Minuten. Durch die Übertragung von Mittelwerten kann nicht nur der Datenverkehr optimiert werden, sondern es werden dadurch auch kleinere Schwankungen oder kurzfristige Strom-/Spannungsspitzen geglättet.

Alternativ oder zusätzlich zum Mittelwert ist es auch möglich, einen Maximalwert und/oder Minimalwert des Stromstärkewerts und/oder des Spannungswerts zu ermitteln und mit dem Übertragungssignal an die externe Empfangseinheit zu übermitteln.

Die Steuereinrichtung kann also ausgebildet sein, einen Mittelwert, einen Maximalwert und/oder einen Minimalwert des Stromstärkewerts und/oder des Spannungswerts in einem vorherbestimmten Zeitintervall zu bestimmen und in ein Übertragungssignal zu integrieren.

Die Übertragungssignale können außerdem einen Zeitstempel umfassen, welcher den Zeitpunkt oder das Zeitintervall für die Bestimmung des übermittelten Stromstärkewerts und/oder Spannungswerts angibt. Dadurch kann der zeitliche Verlauf der Stromstärke bzw. Spannung einfach rekonstruiert werden.

Es ist jedoch auch denkbar, dass auf Seiten der externen Empfangseinheit die eingehenden Übertragungssignale entsprechend zeitlich sortiert oder zugeordnet werden. In diesem Fall ist es nicht erforderlich, dass die Übertragungssignale separate Zeitstempel umfassen.

Es können die Daten basierend auf mehreren, insbesondere auf allen, Sensoreinrichtungen in einem Übertragungssignal zusammengefasst werden. Es ist aber auch denkbar, für die Daten basierend auf jeder der Sensoreinrichtungen ein eigenes Übertragungssignal vorzusehen. Das oder die Übertragungssignale können periodisch oder zu vorherbestimmten Zeiten konfiguriert und übermittelt werden.

Die Sensoreinrichtungen können jeweils einen Messwandler oder Messumformer umfassen. Insbesondere ist es dadurch möglich, die hohen elektrischen Stromstärken oder elektrischen Spannungen, die in Transformatorenstationen auftreten, in eine geringere Stromstärke/Spannung zu wandeln. Diese geringeren Ströme/Spannungen können dann einfacher verarbeitet werden. Insbesondere kann es sich bei dem jeweiligen Messwandler oder Messumformer um einen Wechselstromwandler, insbesondere einen Kleinsignalwandler handeln. Solche Messwandler sind beispielsweise in der Mittelspannungsschaltanlage der Transformatorenstation anwendbar. Ein Beispiel für einen solchen Wechselstromwandler sind sogenannte Rogowski-Spulen. Die Sensoreinrichtungen können daher jeweils eine Rogowski-Spule umfassen. Rogowski-Spulen haben den Vorteil, dass sie ohne aufwändige Montagearbeiten angelegt und wieder entfernt werden können.

Die Steuereinrichtung kann die Messsignale der Sensoreinrichtungen über jeweils einen Analog-Eingang mit nachgeschaltetem Analog-Digital-Wandler (A/D Wandler) empfangen. Insbesondere können die Analogeingänge für eine Eingangsspannung von 0 bis 5V ausgebildet sein. Es hat sich herausgestellt, dass mit solchen Eingängen ein stabiler Betrieb möglich ist. Außerdem ermöglicht die Verwendung analoger Eingänge anstelle digitaler Eingänge eine weitere Verarbeitung des Signals in der Steuereinrichtung. Dafür kann die Steuereinrichtung weitere Elemente zwischen den Analog-Eingängen und den Analog-Digital-Wandlern umfassen.

Die Sensoreinrichtungen können ausgebildet sein, die Stromstärke zu erfassen, wobei die erfasste Stromstärke über einen definierten Widerstand in einen Spannungswert umgewandelt wird. Im Falle einer Rogowski-Spule kann beispielsweise die induzierte Spannung über ein Zeitintegral in eine Stromstärke umgewandelt werden. Diese Stromstärke kann dann an die Steuereinrichtung übermittelt werden. Die erfasste Stromstärke kann über einen definierten Widerstand auch in einen Spannungswert umgewandelt werden. Dadurch ist es möglich, entweder einen Stromstärkewert, einen Spannungswert oder beides zu übertragen.

Die Steuereinrichtung kann außerdem eine Schnittstelle zum Anschluss eines Monitors umfassen. Dadurch ist es möglich, das System nicht nur zur Fernauslese zu verwenden, sondern bei Bedarf auch eine Anzeige anzuschließen, über die die gemessene Stromstärke und/oder Spannung bzw. daraus errechnete Werte, beispielsweise Mittelwerte, dargestellt werden. Dies kann insbesondere bei regelmäßig erforderlichen Inaugenscheinnahmen der Transformatorenstationen vorteilhaft sein.

Das System kann insbesondere auch einen Monitor umfassen, der über die Schnittstelle mit der Steuereinrichtung verbunden ist. Die Steuereinrichtung kann so ausgebildet sein, dass sie auf dem Monitor Stromstärkewerte und/oder Spannungswerte, die von den Sensoreinrichtungen ermittelt wurden, oder daraus errechnete Werte, anzeigt. Dafür kann die Steuereinrichtung entsprechende Anzeigesignale erzeugen.

Der Monitor kann ein externer Monitor sein, der lösbar mit der Schnittstelle verbunden werden kann. In diesem Fall kann die Bedienperson einen Monitor mitführen und bei Bedarf mit einer Schnittstelle einer Steuereinrichtung in einer Transformatorenstation koppeln.

Alternativ kann der Monitor auch ein fest mit der Schnittstelle verbundener Monitor sein. Dieser verbleibt dann mit dem System zur Überwachung der Transformatorenstation in der Transformatorenstation.

Alternativ oder zusätzlich können neben der LoRaWAN Übertragungseinheit eine oder mehrere weitere Übertragungseinheiten zum drahtlosen Übertragen von Daten vorgesehen sein, beispielsweise eine Bluetooth Übertragungseinheit und/oder eine Wireless Local Area Network, WLAN, Übertragungseinheit. Die Steuereinrichtung kann so ausgebildet sein, dass sie über die eine oder mehrere weitere Übertragungseinheit Stromstärkewerte und/oder Spannungswerte, die von den Sensoreinrichtungen ermittelt wurden, oder daraus errechnete Werte, an ein externes Gerät übermittelt. Dadurch können die Werte auch auf einen mobilen Rechner, beispielsweise einem Smartphone oder einem Notebook, der sich in der Nähe der Steuereinrichtung befindet empfangen, gespeichert und/oder angezeigt werden. Im einfachsten Fall kann die Steuereinrichtung entsprechende Anzeigesignale übermitteln, sodass das externe Gerät gewissermaßen als externer Monitor fungiert.

Die Steuereinrichtung kann außerdem eine Anschlusseinheit zum Verbinden mit einer externen Energiequelle, insbesondere Spannungsquelle, umfassen. Die Anschlusseinheit kann insbesondere ein Netzteil umfassen.

Die Steuereinrichtung kann außerdem einen oder mehrere Pufferakkus und eine Ladeelektronik zum Laden der Pufferakkus umfassen. Dadurch ist es möglich, dass auch bei Störungen der externen Energieversorgung ein Betrieb des Systems aufrechterhalten bleiben kann. Ein Vorteil der Übertragung in LoRaWAN-Netzwerken ist der verhältnismäßig geringe Stromverbrauch (etwa 100 mA für eine Übermittlung). Durch die Pufferakkus kann der Betrieb über längere Zeit aufrechterhalten bleiben. Durch die Ladeelektronik können der eine oder die mehreren Pufferakkus im Falle einer funktionierenden externen Energiequelle wieder geladen werden. Als "Pufferakku" oder Pufferakkumulator wird hierin ein wiederaufladbarer Energiespeicher bezeichnet, der aus einer oder mehreren zusammengeschalteten Sekundärzellen besteht. Beispielsweise kann der wenigstens eine Pufferakku zwei wiederaufladbare Sekundärzellen (z.B. IEC Größe R6) umfassen.

Die Erfindung stellt außerdem ein Verfahren nach Anspruch 10 zum Überwachen einer Transformatorenstation bereit. Durch ein derartiges Verfahren kann für einzelne Abgänge der Transformatorenstation die Last bzw. Auslastung bestimmt werden. Diese Information kann wiederum herangezogen werden, um die Transformatorenstation derart zu steuern oder zu regeln, dass die Stabilität der Stromversorgung optimiert wird.

Beispielsweise kann die Ermittlung der Auslastung zur Identifikation von Engpässen genutzt werden. Entsprechend kann präventiv beispielsweise durch den Einbau zusätzlicher Transformatoren Engpässen entgegengewirkt werden. Insgesamt ist es dadurch also möglich, das Stromnetz möglichst "ausgeglichen" zu gestalten.

Das Verfahren kann insbesondere mit einem oben beschriebenen System durchgeführt werden, welches eines oder mehrere der oben genannten Merkmale aufweisen kann.

Weitere Merkmale und Vorteile der Erfindung werden nachfolgend anhand der beispielhaften Figuren erläutert. Dabei zeigt
- Figur 1: schematisch den Aufbau einer Transformatorenstation mit einem darin angeordneten System zur Überwachung der Transformatorenstation;
- Figur 2: den schematischen Aufbau eines Systems zur Überwachung einer Transformatorenstation, wie es in dem Beispiel der Figur 1 Anwendung finden kann; und
- Figur 3: eine Illustration der Datenübermittlung mit einem System gemäß Figur 2.

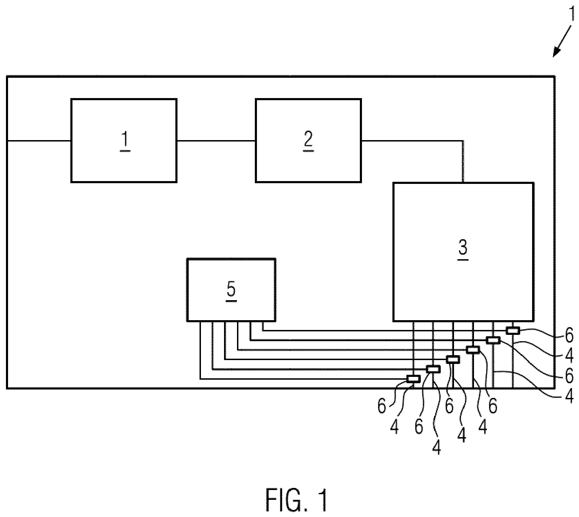

Figur 1 zeigt schematisch und stark vereinfacht den Aufbau einer Transformatorenstation 1. Transformatorenstationen als solches sind bekannt. Sie dienen dazu, elektrische Energie aus dem Mittelspannungsnetz mit einer elektrischen Spannung von 10 bis 36 kV auf für die in Niederspannungsnetzen verwendeten 400/230 V zu transformieren. Es sind Transformatorenstationen bekannt, die in begehbaren Gebäuden angeordnet sind. Es sind inzwischen allerdings auch nicht begehbare Lösungen bekannt, sogenannte "Kompakttransformatorenstationen".

Die Transformatorenstation 1 umfasst in an sich bekannter Weise eine Mittelspannungsschaltanlage 1, welche über einen Eingang mit dem Mittelspannungsnetz verbunden ist. Die Mittelspannungsschaltanlage 1 ist mit einem Transformator 2 verbunden, welcher die Spannungsumwandlung von Mittelspannung auf Niederspannung realisiert. An dem Transformator 2 angeschlossen ist eine Niederspannungsverteilung 3, welche die elektrische Energie auf eine Mehrzahl von Ableitungen 4 verteilt. Beispielsweise kann jeder Ableitung 4 ein Straßenzug einer Ortschaft oder ein Gebäude, insbesondere ein Industriegebäude, entsprechen.

Es ist bekannt, in Transformatorenstationen Schleppzeigersensoren zu verwenden, um die maximalen Stromstärkewerte zu bestimmen, die in vorbestimmten Leitungsabschnitten der Transformatorenstationen auftreten. Auch Kurzschlusssensoren und/oder Erdschlusssensoren finden Anwendung. An diesen bekannten Lösungen ist jedoch nachteilig, dass die genannten Sensoren durch Bedienpersonen ausgelesen werden müssen. In größeren Städten, in denen mehrere tausend Transformatorenstationen eingesetzt werden, ist eine vernünftige Überwachung der Funktion der Transformatorenstationen damit kaum möglich.

Erfindungsgemäß ist in Figur 1 daher ein System zur Überwachung der Transformatorenstation 1 vorgesehen, welches in diesem Beispiel sechs Sensoreinrichtungen 6 umfasst, mit denen die Stromstärke und/oder Spannung in jeweils einem separaten Leitungsabschnitt der Transformatorenstation 1 bestimmt werden kann. In dem Beispiel der Figur 1 sind die Sensoreinrichtungen 6 im Bereich der Abgänge 4 zum Niederspannungsnetz, also in oder unmittelbar nach der Niederspannungsschaltanlage 3 angeordnet. Dadurch kann ortsaufgelöst festgestellt werden, welche Stromstärken beispielsweise in einzelne Straßenzüge eingespeist werden.

Mit den Sensoreinrichtungen 6 über elektrische Leitungen verbunden ist eine Steuereinrichtung 5, welche ausgebildet ist, Messsignale der Sensoreinrichtungen 6 zu empfangen und in Übertragungssignale zur drahtlosen Übermittlung über ein Long-Range-Wireless-Area-Netzwerk, LoRaWAN, zu konvertieren. Die Übertragungssignale umfassen dabei jeweils einen Stromstärkewert und/oder Spannungswert und eine Identifikation des zugehörigen Leitungsabschnitts. Eine hier in Figur 1 nicht dargestellte Übertragungseinheit der Steuereinrichtung 5 ist ausgebildet, die ermittelten Übertragungssignale über das LoRaWAN-Netzwerk an eine externe Empfangseinheit zu übermitteln, beispielsweise an eine Leitstelle, die somit über jeden Abgang 4 der Transformatorenstation 1 aktuelle Informationen zum Betriebszustand fernauslesen kann. Damit ist gegenüber dem Stand der Technik eine deutlich bessere Überwachung der Transformatorenstation möglich.

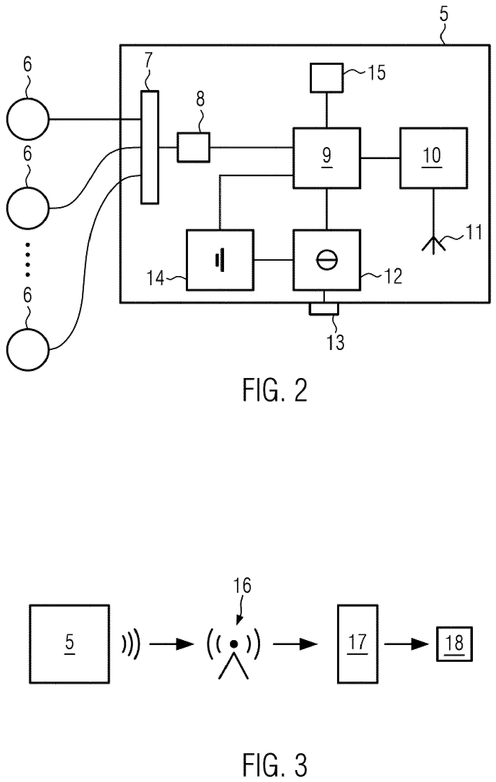

Figur 2 zeigt Details des Systems zur Überwachung der Transformatorenstation, welche in Figur 1 Anwendung findet. Die Sensoreinrichtungen 6 sind als Rogowski-Spulen ausgebildet, welche um die Leitungsabschnitte 4 der Figur 1 gelegt werden können. Die Rogowski-Spulen 6 sind leitend mit einem Eingang 7 der Steuereinrichtung 5 verbunden. Der Eingang 7 ist bevorzugt ein analoger Eingang. Die empfangenen Signale werden dann über einen Analog-Digital-Wandler 8 an einen Prozessor 9 übermittelt. Der Prozessor 9 kann mit einer hier nicht dargestellten Speichereinheit versehen sein, um temporär oder dauerhaft empfangene oder berechnete Werte speichern zu können. In der schematischen Abbildung der Figur 2 ist nur ein Analog-Digital-Wandler 8 dargestellt. Tatsächlich ist jedoch für jede Sensoreinrichtung 6 und den zugehörigen Anschluss im Eingang 7 ein Analog-Digital-Wandler vorgesehen. Neben dem Analog-Digital-Wandler 8 kann auch noch ein definierter Widerstand vorgesehen sein, um das von den Rogowski-Spulen gelieferte Stromstärkesignal in ein Spannungssignal umzuwandeln.

Der Prozessor 9 ist mit einer Übertragungseinheit 10 verbunden, welche wiederum mit einer Antenne 11 verbunden ist. Die Übertragungseinheit 10 ist in Verbindung mit der Antenne 11 ausgebildet, um Übertragungssignale, welche vom Prozessor 9 empfangen werden, über ein LoRaWAN-Netzwerk an eine externe Empfangseinheit zu übermitteln.

Der Prozessor 9 kann insbesondere ausgebildet sein, Mittelwerte der von den Sensoreinrichtungen 6 übermittelten und gegebenenfalls weiterverarbeiteten Messsignale zu bestimmen, so dass ein über eine vorbestimmte Zeitdauer gemittelter Stromstärkewert und/oder Spannungswert erhalten wird. Beispielsweise können die jeweiligen Werte über ein Zeitfenster von 15 Minuten gemittelt werden. Alle 15 Minuten kann dieser Mittelwert dann als Teil des Übertragungssignals durch die Übertragungseinheit 10 und die Antenne 11 übermittelt werden. Dadurch ist es möglich, Informationen über den zeitlichen Verlauf der Stromstärke/Spannung zu erhalten. Durch die Mittelwertbildung kann der Netzwerkverkehr und die verbundene Datenmenge auf das erforderliche Maß eingestellt werden. Alternativ oder zusätzlich können auch Maximalwerte und/oder Minimalwerte übertragen werden.

Die Signalverarbeitung kann in einem konkreten Beispiel also wie folgt aussehen: Das analoge Signal der Sensoreinrichtungen wird mit einer Genauigkeit von mindestens 10 bit in einen digitalen Wert gewandelt. Die Erfassung und Umwandlung der Messwerte in Digitalwerte erfolgt im Sekundentakt. Hierbei wird der je Sensoreinrichtung auftretende Minimalwert und Maximalwert erfasst und gespeichert sowie ein Mittelwert der jeweiligen Messwerte gebildet. Diese Werte werden am Ende einer vorherbestimmten Periode (z.B. 15 min) übertragen. Daraus ergeben sich folgende Übertragungswerte für jede der Sensoreinrichtungen: Minimum, Maximum, Durchschnitt, Datum, Uhrzeit und eine Identifikation des Leitungsabschnitts. Es versteht sich, dass die Erfindung in keiner Weise auf dieses konkrete Beispiel beschränkt ist.

Es ist denkbar, dass basierend auf den Messsignalen einer jeden der Sensoreinrichtungen ein eigenes Übertragungssignal übermittelt wird. Es kann jedoch auch nur ein Übertragungssignal für die Informationen bezüglich aller Sensoreinrichtungen konfiguriert und übermittelt werden.

Das System kann so ausgebildet sein, dass es periodisch oder zu vorherbestimmten Zeiten ein oder mehrere Übertragungssignale basierend auf den Messsignalen der Sensoreinrichtungen erstellt und übermittelt. Beispielsweise können alle 15 Minuten ein oder mehrere Übertragungssignale erstellt und übermittelt werden.

In Figur 2 ist außerdem eine Energiequelle 12 zu sehen, welche über einen Anschluss 13 mit einer externen Energiequelle verbunden sein kann. Im Normalbetrieb kann diese Energiequelle 12 die elektrischen Verbraucher der Steuereinrichtung 5 mit Energie versorgen. In der schematischen Abbildung der Figur 2 ist nur der Prozessor 9 und der später noch genauer spezifizierte Energiepuffer 14 mit der Energiequelle 12 verbunden. Tatsächlich kann die Energiequelle 12 jedoch mit allen elektrischen Verbrauchern der Steuereinrichtung 5 verbunden sein, so dass diese mit der erforderlichen Energie versorgt werden können.

Die eben erwähnte Puffereinheit 14 umfasst einen oder mehrere Pufferakkus und eine Ladeelektronik zum Laden der Pufferakkus. Im Falle eines Stromausfalls der externen Energiequelle kann die für die Funktion des Systems erforderliche Energie aus dem oder den Pufferakkus bezogen werden. Sobald die externe Energiequelle wieder zur Verfügung steht, kann die Ladeelektronik verwendet werden, um die Pufferakkus wieder zu laden. Auch hier kann die Puffereinheit mit allen elektrischen Verbrauchern der Steuereinrichtung 5 verbunden sein, so dass diese mit der erforderlichen Energie versorgt werden können.

Figur 2 zeigt außerdem einen Anschluss 15 für einen externen Monitor. Dieser Anschluss 15 erlaubt es, die Messwerte der Sensoreinrichtungen auch vor Ort zur Anzeige zu bringen, und nicht nur für die Fernauslese bereitzustellen. Dies kann für die Kontrolle und Wartung der Transformatorenstation vorteilhaft sein. Es wäre auch denkbar, einen fest mit dem Anschluss 15 verbundenen "internen" Monitor vorzusehen. Dadurch können Informationen unmittelbar angezeigt werden, ohne dass zuvor ein externer Monitor angeschlossen werden müsste.

Figur 3 zeigt nochmals schematisch, wie die Übertragung der Übertragungssignale im LoRaWAN-Netzwerk vor sich geht. Die Steuereinrichtung 5 übermittelt mittels ihrer Übertragungseinheit 10 und der damit verbundenen Antenne 11 die Übertragungssignale an eine Sende-Empfangsvorrichtung 16, welche mit einem Serverrechner 17 verbunden ist. Auf den Serverrechner 17 kann ein Anwendungsrechner 18, beispielsweise ein Rechner der Stromleitstelle zugreifen. Dadurch können die Informationen für den Anwendungsrechner 18 bereitgestellt werden. Das LoRaWAN Netzwerk umfasst hier also den Serverrechner 17, die Sende-Empfangsvorrichtung 16 und die Steuereinrichtung 5 mit ihrer Übertragungseinheit 10 und der damit verbundenen Antenne 11.

Der Serverrechner 17, die Sende-Empfangsvorrichtung 16 und der Anwendungsrechner 18 können mit einer unterbrechungsfreien Stromversorgung, USV, gekoppelt sein. Dadurch kann die Überwachung der Transformatorenstationen auch bei einem Stromausfall aufrechterhalten bleiben und zu einer schnelleren Klärung des zugrundeliegenden Problems beitragen.

Über die Sende-Empfangsvorrichtung 16, auch Gateway genannt, kann eine Vielzahl von Systemen zur Überwachung von Transformatorenstationen gemäß der Erfindung für unterschiedliche Transformatorenstationen mit dem Serverrechner 17 kommunizieren. Es können auch mehrere Sende-Empfangsvorrichtungen 16 mit dem Serverrechner 17 verbunden sein. Die Netztopologie des LoRaWAN Netzes hängt von den speziellen Gegebenheiten der Anwendung ab. Hierin wurde die einfachste Variante mit einer Sende-Empfangsvorrichtung 16, einem Serverrechner 17 und einem System zur Überwachung von Transformatorenstationen beschrieben, die Erfindung ist aber nicht darauf beschränkt, sondern in beliebigen LoRaWAN Netzwerken anwendbar.

Es versteht sich, dass in den zuvor beschriebenen Ausführungsbeispielen genannte Merkmale nicht auf diese speziellen Kombinationen beschränkt und auch in beliebigen anderen Kombinationen möglich sind.

## Patentansprüche

1. System zur Überwachung einer Transformatorenstation (1), umfassend:
wenigstens zwei Sensoreinrichtungen (6) zur Erfassung der Stromstärke und/oder Spannung in jeweils einem Leitungsabschnitt einer Transformatorenstation (1); und
eine mit den Sensoreinrichtungen (6) verbundene Steuereinrichtung (5), welche ausgebildet ist, Messsignale der Sensoreinrichtungen (6) zu empfangen und in Übertragungssignale zur drahtlosen Übermittlung über ein LoRaWAN Netzwerk zu konvertieren, wobei die Übertragungssignale jeweils einen Stromstärkewert und/oder Spannungswert und eine Identifikation des zugehörigen Leitungsabschnitts umfassen; und
wobei die Steuereinrichtung (5) außerdem eine Übertragungseinheit (10) umfasst, die ausgebildet ist, die Übertragungssignale drahtlos über ein LoRaWAN Netzwerk an eine externe Empfangseinheit zu übermitteln.

2. System nach Anspruch 1, wobei der Stromstärkewert und/oder Spannungswert der Übertragungssignale ein Mittelwert über einen vorgegebenen Zeitraum ist.

3. System nach Anspruch 1 oder 2, wobei die Sensoreinrichtungen (6) jeweils einen Messwandler, insbesondere eine Rogowski-Spule, umfassen.

4. System nach einem der vorangegangenen Ansprüche, wobei die Steuereinrichtung (5) die Messsignale der Sensoreinrichtungen (6) über einen Analogeingang (7) mit nachgeschaltetem Analog-Digital-Wandler (8) empfängt.

5. System nach einem der vorangegangenen Ansprüche, wobei die Sensoreinrichtungen (6) ausgebildet sind, die Stromstärke zu erfassen und die erfasste Stromstärke über einen definierten Widerstand in einen Spannungswert umgewandelt wird.

6. System nach einem der vorangegangenen Ansprüche, wobei die Steuereinrichtung (5) außerdem eine Schnittstelle (15) zum Anschluss eines Monitors umfasst.

7. System nach Anspruch 6, außerdem umfassend einen Monitor, der über die Schnittstelle (15) mit der Steuereinrichtung (5) verbunden ist.

8. System nach einem der vorangegangenen Ansprüche, wobei die Steuereinrichtung (5) außerdem eine Anschlusseinheit (12, 13) zum Verbinden mit einer externen Energiequelle umfasst.

9. System nach Anspruch 8, wobei die Steuereinrichtung (5) außerdem einen oder mehrere Pufferakkus und eine Ladeelektronik zum Laden der Pufferakkus umfasst.

10. Verfahren zum Überwachung einer Transformatorenstation (1) umfassend die Schritte:
(a) Bereitstellen eines Systems nach einem der vorangegangenen Ansprüche;
(b) Anordnen der wenigstens zwei Sensoreinrichtungen (6) im Bereich unterschiedlicher Leitungsabschnitte der Transformatorenstation (1);
(c) durch die Steuereinrichtung (5) des bereitgestellten Systems, Empfangen von Messsignalen der Sensoreinrichtungen (6) und Konvertierung der empfangenen Messsignale in Übertragungssignale zur drahtlosen Übermittlung über ein LoRaWAN Netzwerk, wobei die Übertragungssignale jeweils einen Stromstärkewert und/oder Spannungswert und eine Identifikation des zugehörigen Leitungsabschnitts umfassen; und
(d) durch die Übertragungseinheit (10) der Steuereinrichtung (5), drahtloses Übermitteln der Übertragungssignale über ein LoRaWAN Netzwerk an eine externe Empfangseinheit.
